# EUROPEAN PATENT APPLICATION

(11) **EP 2 413 520 A1**
(43) Date of publication of application: **01.02.2012**
(21) Application number: 10305822.8
(22) Date of filing: 26.07.2010
(51) Int. Cl.: H04B 10/12, H03G 3/00

(54) **A method for transmission and amplification of signals, a transmitting device and a receiving device therefor**

(71) Applicant: Alcatel Lucent, 75007 Paris (FR)
(72) Inventor: Wiegner, Dirk, 71409, Schwaikheim (DE); Jueschke, Patrick, 75428, Illingen (DE)
(74) Representative: Kleinbub, Oliver

(57) **Abstract**

The invention concerns a method for transmission of signals from a transmitting device (BS) to at least one receiving device (RAH1) comprising at least one amplification unit (AU1) for signal amplification, wherein said signals are transmitted over at least one optical connection (OF1) from the transmitting device (BS) to the at least one receiving device (RAH1), wherein electrical baseband signals are converted into optical signals in the transmitting device (BS), the optical signals are converted into electrical radio frequency signals in an opto-electrical converter (OE1) located in said at least one receiving device (RAH1), and the electrical radio frequency signals are amplified in the at least one amplification unit (AU1) by means of a neural network NN, a transmitting device and a receiving device therefor.

## Description

### Field of the invention

The invention relates to a method for transmission of signals from a transmitting device to at least one receiving device comprising at least one amplification unit for signal amplification, wherein said signals are transmitted over at least one optical connection from the transmitting device to the at least one receiving device, and a transmitting and a receiving device adapted to perform said method.

### Background

The coverage of a certain service area in a cellular radio network is provided by several radio base stations, which are connected to a core network to serve connections to and from mobile users within the service area. A radio base station contains a baseband unit and at least one antenna unit. In order to increase radio coverage and capacity, modern base stations use several sector antennas.

In order to increase flexibility of the base stations, it is desirable to allow the antennas to be located remote from the baseband unit. This has lead to the development of active antenna systems which are also termed remote antenna heads. Typically, one remote antenna head contains one sector antenna, but there are also systems known, which have remote antenna heads with more than only one sector antenna.

The base stations are preferably connected with the remote antenna heads by means of optical fibers, which supports highly efficient and flexible future networks as well as high potential for distribution over wide distances with low loss. Conventional radio-over-fiber scenarios involve optical transmission of analogue signals between a base station and a transmitter with an amplifier in a remote antenna head. Alternatively, a so-called CIPRI-connection can be used for connecting the base stations with the remote antenna heads

An example for the implementation of a radio-over-fiber concept in a cellular radio network using a two-fiber-ring is given in the European patent EP 1553791 B1.

### Summary

A problem of such solutions, especially when the remote antenna head, which comprises an active antenna element or an array of active antenna elements, is far away from the baseband/control unit is the control of the active antenna elements itself and thus to achieve optimized operation. Several components of such elements/arrays like e.g. power amplifier, filter, etc. allow for adaptation by suitable control, which becomes complex and difficult over wide distances, amongst others also due to the number of controllable components and functions. In addition, also the provision of the information necessary for controlling the components is difficult over wide distances, again especially when the amount of information increases.

Thus, as current solutions apply control of the elements/array mainly by the baseband/control unit, many of the possible control functions are currently not used, amongst others due to complexity of control between the baseband/control unit and the distributed transmit elements/arrays.

The object of the invention is thus to propose a method for transmission of signals from a transmitting device to at least one receiving device comprising at least one amplification unit for signal amplification with reduced effort for controlling the at least one amplification unit.

The basic idea of the invention is to add in the remote antenna head either a neural network directly to each active antenna element or a common neural network to control a number of antenna elements, i.e. an array of active antenna elements. By this procedure, the necessary control effort between the base station and the distributed active antenna element or the array of active antenna elements can clearly be reduced, since the neural network and thus the controlling unit is located close to the components to be controlled. Additionally, by a self-learning neural network, the system will adaptively be improved by itself.

Furthermore, the application of a neural network for controlling active antenna elements adds flexibility which leads to an improved efficiency of the active antenna elements. Currently, several important parts of a conventional base station are fixed or in best case controlled by a central unit which in conventional base stations controls the components through different layers, making the controlling difficult. As the controlled parts cannot react autonomously on different scenarios, the best performance will often not be achieved.

Typically, power amplifiers in base stations are designed as conventional class-AB based amplifiers with fixed supply voltage and a matching network matched for a single standard application working in base stations with fixed set-ups due to the specific requirements, as are carriers, frequency ranges, power class, and so on. The solutions based on class-AB amplifiers only achieve moderate efficiency for fixed supply voltage with clear efficiency decrease for increased back-off operation, e.g. when signal peak-to-average increases for example in case of multi-standard operation or in case of night and day load scenarios. For example, in the night there is usually less load on the base station than in the mid of the day. It is therefore very desirable to improve efficiency and performance of power amplifiers, base stations and radio communication networks operating with such base stations as well as to increase flexibility and self-adaptability for example for advanced support of multi-standard and multi-band applications like software-defined radio or cognitive radio, location-based autonomous set-up, and so on.

Thus, the object is achieved by a method for transmission of signals from a transmitting device to at least one receiving device comprising at least one amplification unit for signal amplification, wherein said signals are transmitted over at least one optical connection from the transmitting device to the at least one receiving device, wherein
● electrical baseband signals are converted into optical signals in the transmitting device,
● the optical signals are converted into electrical radio frequency signals in an opto-electrical converter located in said at least one receiving device,
● and the electrical radio frequency signals are amplified in the at least one amplification unit with the steps of
   - inputting the electrical radio frequency signals to be amplified,
   - outputting amplified radio frequency output signals,
   - and tuning or configuring at least one tunable amplification parameter in accordance with at least one input parameter, wherein
   - said tuning, or configuring of said at least one tunable amplification parameter is carried out by steering it by means of at least one neural network on the basis of said at least one input parameter input to said at least one neural network.

The object is furthermore achieved by a transmitting device for transmission of signals to at least one receiving device, wherein said transmitting device comprises
- a digital signal processing unit for generating electrical digital signals,
- a first electro-optical converter for converting said electrical digital signals into first optical digital signals on baseband level,
- a second electro-optical converter for converting said electrical digital signals into second optical digital signals on baseband level,
- a third electro-optical converter for converting electrical radio frequency carrier signals into optical radio frequency carrier signals,
- an optical adder for adding the second optical digital signals on baseband level and the optical radio frequency carrier signals,
- and at least one optical output that is adapted to transmit the first optical digital signals on baseband level, the second optical digital signals on baseband level, and the optical radio frequency carrier signals.

The object is furthermore achieved by a receiving device for reception of signals sent from a transmitting device, wherein said receiving device comprises
- at least one optical input that is adapted to receive optical signals,
- an opto-electrical converter that is adapted to convert optical signals into electrical radio frequency signals,
- and at least one amplification unit configured for amplifying said electrical radio frequency signals, said amplification unit comprising
   - a radio frequency signal input terminal for inputting said electrical radio frequency input signal to be amplified by said amplification unit,
   - a radio frequency signal output terminal for outputting radio frequency output signals amplified by said amplification unit, and
   - at least one tunable or configurable element,
   - wherein said amplification unit further comprises or is coupled with at least one neural network configured to steer said at least one tunable or configurable element on the basis of at least one input parameter input to said at least one neural network.

In other words, in order to address the above-identified problems, it is thus proposed to transmit signals from the digital part of a base station preferably digitally via an optical connection, as e.g. an optical fibre, to a distributed, even far remotely located, amplification unit, which is controlled by a neural network, followed by an antenna network and an antenna.

An underlying concept of the invention is to create an intelligent amplification unit that has different tunable elements allowing tuning and adapting the amplification unit to different scenarios, possibly while the amplification unit is working and learning about the conditions in the specific location and specific requirements. Such learning and adapting procedures lead to a more optimized performance of e.g. the power amplifier or the whole amplification unit and additionally lead to a certain predictability of operating conditions, allowing to adapt and optimize the power amplifier's or amplification unit's suitability and accurate timing.

According to a first important aspect of the invention, the above object is solved by an amplification unit configured for amplifying a radio frequency signal in a communication network, said amplification unit comprising a radio frequency signal input terminal for inputting a radio frequency input signal to be amplified by said amplification unit, a radio frequency signal output terminal for outputting a radio frequency output signal amplified by said amplification unit, and at least one tunable or configurable element, wherein said amplification unit further comprises or is coupled with at least one neural network configured to steer said at least one tunable or configurable element on the basis of at least one input parameter input to said at least one neural network.

Thus, the core of the intelligent, i.e. brain-based, amplification unit according to the invention may be devised as one or more neural networks. These neural networks typically receive several input parameters which are processed to steer several tunable or adaptable or configurable elements of the amplification unit, respectively. The neural networks will learn before and/or while they are working. The learning may be performed by providing the radio frequency output signal of the amplification unit, a property derived from the radio frequency output signal, or a property derived from the radio frequency signal after different processing steps in the amplification unit, as e.g. filtering or linearization, as input parameters to the neural network, thus providing a feedback about the quality of the tuning of the amplification unit. It may also be possible to use a network type being known as a feedback network, a feedback from the outputs to the inputs of the network is provided per-se, such that no additional, i.e. external, feedback may be required.

In any case, the neural networks may learn about the different requirements, for example for different scenarios, know about the current daytime and thus can control the amplification unit with their newest knowledge. Thus, the amplification unit adjusts itself independently in the specific environment and can thus optimize the tunable or adaptable or configurable parameters according to the specific conditions.

If components of the amplification unit, like the power amplifier, are controlled by means of such a neural network, a complex controlling through different communication layers will be clearly relaxed or can even be omitted due to the self-adaptation of the power amplifier by means of its neural network.

In an advantageous development of the amplification unit the at least one tunable or adaptable or configurable element comprises at least one or more of the following: power amplifier's gate biasing, power amplifier's drain biasing, and switchable or tunable radio frequency signal impedance and/or frequency matching network(s). Typically, the power amplifier, which is a part of the amplification unit, comprises at least one power transistor, like e.g. a field effect transistor, the gate and/or the drain terminal thereof being controlled by a (DC) bias signal through a gate/drain biasing element. In particular, a modulator may be used for providing an adaptive supply voltage to the drain terminal, the supply voltage being dependent e.g. on an envelope of the radio frequency input signal, in particular when the power amplifier is used in an envelope tracking, ET, or envelope elimination and restoration, EER, configuration. The switchable or tunable impedance matching networks may comprise at least one switchable element, as e.g. PIN diodes or MEMS switches, for activating/deactivating one or more fixed impedance matching elements, like e.g. capacitors having fixed impedance etc.. Alternatively or in addition, at least one tunable element, for instance a tunable capacitor, with variable impedance, may be provided. Both the switchable and tunable element(s) may be controlled/steered by the at least one (artificial) neural network. In case of a class S amplifier, the control of a bandpass delta sigma modulator or pulse length modulator, the supply of transistors, filters, or alternative coding, as e.g. Manchester Coding if the modulator is realized in field programmable gate arrays, may also be controlled/steered by the at least one (artificial) neural network.

Further advantageously, the at least one input parameter input to the at least one neural network comprises one or more of the parameters: radio frequency input signal, radio frequency output signal, number of radio frequency carriers, number of signal channels, current load, signal properties, signal envelope, time, e.g. time of day / night / clock, communication standard requirements, addressed fragmented frequency bands, and communication standard distribution. Specific properties of the current input/output radio frequency signal may include its center frequency, its peak-to-average ratio, and the signal standard. Also, the time (of day) may be used as an input to the neural network in order to adapt the elements of the amplification unit, as e.g. the power amplifier to different load scenarios (daytime / nighttime).

Further advantageously, the at least one neural network is configured to decide based on the input parameters about a required configuration of the amplification unit by controlling the at least one tunable or adaptable or configurable element. For this purpose, the output(s) of the neural network are provided to the tunable or configurable element(s). The decision about the required configuration of the amplification unit is made in dependence of the current input parameters applied to the network and on a state of the neural network which is represented by the weights of the connections between the nodes of the neural network. It will be understood that before operation, the neural network may be trained using input parameter sets which should be mapped to specific output parameter sets for given (pre-defined) configurations of the amplification unit, the deviation between the outputs produced by the network and the given output parameter sets being used for adapting the weights of the network accordingly as is known in the art (back-propagation).

Moreover, the at least one neural network may be configured to learn about current conditions or scenarios of the amplification unit and will be able to recognize conditions or scenarios for the future based on the at least one input parameter. This is possible as the weights of the connections between the nodes are adapted dynamically and as feedback about the output(s) of the neural network is provided to the inputs of the neural network. When a neural network type is used which does not provide an internal feedback, an external feedback path may be provided for performing the self-learning, e.g. providing the radio frequency output as an input to the network.

According to a second aspect the above object is solved by a receiving device comprising at least one (intelligent) amplification unit according to the invention as specified above.

Advantageously in the present method for power amplification, the at least one tunable amplification parameter comprises at least one parameter selected from the group of: power amplifier's gate biasing modulation parameter(s), power amplifier's drain biasing modulation parameter(s), and switchable or tunable RF signal impedance / frequency matching parameters. Thus, the amplifier biasing and/or the input/output impedance of the power amplifier may be optimized/adapted for different amplifier configurations. It will be understood, however, that when more sophisticated amplifier types such as digital amplifiers (e.g. of Class-s type) are used, different/further amplifier parameters may be adjustable. For example, when a Class-S concept is used, modulator parameters of a delta-sigma or a pulse-length modulator e.g. in combination with a self-linearization of the Class-S amplifier may be adjusted under control of the neural network. Additionally, parameters such as biasing of the switch-mode stage (e.g. in Class-D configuration) could be controlled and optimized for the current operation conditions by the neural network.

Further advantageously in the present method, the at least one input parameter to the at least one neural network comprises one or more parameters such as RF input signal, RF output signal, number of RF carriers, number of signal channels, current load, signal properties, signal envelope, and time. The number of RF carriers / signal channels, and, in particular, their respective center frequencies may be used to perform adaptive frequency matching of corresponding frequency matching elements using the neural network. It will be understood that also parameters different from those cited above may be provided as input parameters to the neural network.

Further advantageously in the present method for power amplification in the remote antenna head, the at least one neural network decides based on the input parameters about a required amplification configuration by controlling the at least tunable or adaptable or configurable parameter. To be more precise, typically the output(s) of the neural network will represent a weighted sum of the input parameters, the weights being defined for each of the connections between two nodes of different layers of the network.

Last but not least in the present method for power amplification in the remote antenna head, the at least one neural network learns about current conditions or scenarios and recognizes conditions or scenarios for the future based on the at least one input parameter. Typically, after training the neural network by using a plurality of training parameter sets for specific conditions or scenarios, the neural network will be able to adapt to other, similar scenarios for which the neural network has not been trained, resulting in an (almost) optimum performance also for these un-trained scenarios or conditions. Moreover, a dynamical adjustment / learning of the neural network may be performed, in particular when feedback about the quality of the adjustment is provided to the neural network, for example in the form of at least one input parameter which is related to at least one property of the amplified RF signal, or when the neural network itself provides a feedback from its output(s) back to its input(s).

The inventive idea as specified above is not only suitable for the amplification unit. It is moreover possible to control more parts, maybe the whole remote antenna head by one or several neural networks.

### Brief description of the figures

Fig. 1 schematically shows an embodiment of an amplification unit line-up controlled by a neural network.
Fig. 2 schematically shows the principle configuration of a neural network with a number of exemplary possible input parameters and output parameters for an amplification unit.
Fig. 3 schematically shows a cellular communication network with a base station and remote antenna heads in which the invention can be implemented.
Fig. 4 schematically shows a transmitting device comprising a digital signal processing unit linked by an optical connection with a receiving device comprising an amplification unit and a neural network for controlling the amplification unit according to an embodiment of the invention.

### Description of the embodiments

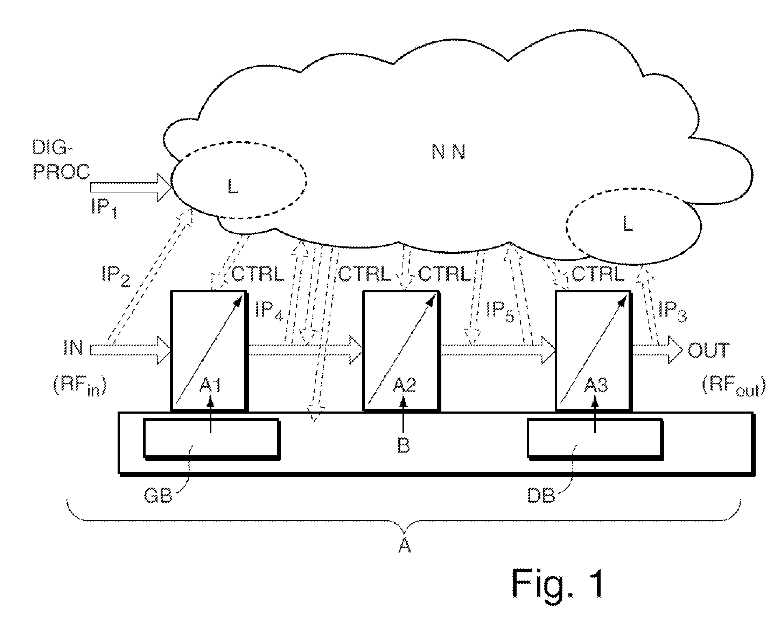

The schematic diagram of **Fig. 1** shows an embodiment of an intelligent amplification unit A having, in the present example, three amplifier stages A1, A2, A3. The first amplifier stage is a pre-amplifier stage comprising matching networks and transistors and receiving an RF input signal "RFin" input through an RF input terminal IN. The first amplifier stage A1 is connected to the second amplifier stage A2 which is devised as a driver amplifier stage comprising matching networks and transistors. From there, the RF signal is further lead to a final output amplifier stage A3 where it is provided as an output signal "RFout" through an output terminal OUT.

It will be understood that when the intelligent amplification unit A is devised as a digital power amplifier, e.g. as a class-S amplifier, the first amplifier stage A1 may be devised as a Delta-Sigma- or pulse-width modulator, the second amplifier stage A2 may be devised as a switching stage (class-D amplifier stage including power transistor(s) and matching lines, drivers, etc.), and the third amplifier stage may be devised as a reconstruction filter.

The embodiment of the amplification unit A further comprises a biasing unit B including a gate biasing unit GB and a drain biasing unit, e.g. comprising a bias modulator DB or a switching unit for adapting the bias voltage to e.g. different load conditions (daytime / nighttime). The gate biasing unit GB has the function of generating a gate bias for one, two or all amplifier stages A1, A2, A3. The drain bias modulator DB is configured to generate e.g. a modulated or switched drain bias which is applied to a drain terminal of one, two or all amplifier stages A1, A2, A3 of the brain based amplification unit A. At least one element of the amplification unit A, for example, the gate biasing unit GB and/or the drain bias unit, e.g. comprising a bias modulator DB are configured as tunable or adaptable or configurable element(s). The intelligent amplification unit A further comprises or is coupled with a neural network NN which is represented in Fig. 1 by curved lines like a cloud.

The neural network NN gets input parameters IP1 from a digital signal processing unit DIG-PROC and further input parameters IP2, IP3 which are derived from the input signal RFin and the RF output signal RFout, respectively. Furthermore, the neural network NN gets input parameters IP4, IP5 from the outputs of the first and second amplifier stages A1, A2 for specifically controlling these stages independently from the third stage A3. The input parameters designated with reference numbers IP1 to IP5 may relate to input parameters such as the time/clock, input signal RFin, output signal RFout, the number of carriers of the signal, the number of channels of the signal, the current load, and so on.

These input parameters are processed in the neural network NN to steer at least one of the tunable or adaptable or configurable elements of the amplification unit A. The neural network NN will learn while it is working. The type of learning depends on the type of application and on the amplifier type, as e.g. power amplifier, transceiver, etc.. Typically, reinforcement learning or unsupervised learning is used. Unsupervised learning, which is in general provided by so-called Kohonen networks, has been proven to be advantageous in combination with a power amplifier. The learning function is surrounded by broken lines and indicated by the letter "L". The neural network NN learns about the different requirements e.g. for different scenarios, knows about the current daytime and can thus control the tunable or adaptable or configurable element(s) in dependence of the input parameters IP1 to IP5. Apart from the Gate biasing unit GB and the Drain biasing modulator DB of the amplification unit A, the tunable or adaptable or configurable elements may form part of impedance or frequency matching networks provided for impedance/frequency matching of the respective amplifier stages A1 to A3. The control functions of the neural network NN are indicated in Fig. 1 by respective arrows in broken lines and designated as "CTRL".

Thus, the amplification unit A is adapted to adjust itself independently in its specific environment and can optimize tunable / adaptable / configurable parameters of the at least one tunable or configurable element to the specific conditions. Since the amplification unit A comprises its own neural network NN, a complex controlling through different communication layers will be clearly relaxed or can even be omitted due to the self-adaptation of the amplification unit A by the neural network NN.

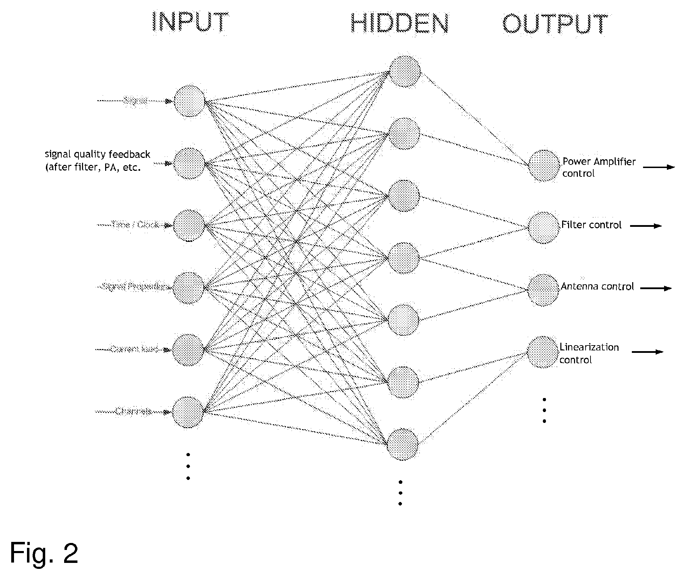

**Fig. 2** shows the schematic of the configuration of an exemplary (feed-forward) neural network NN suitable for use in the present invention and having three layers of nodes, respectively devised as an input layer, a hidden layer and an output layer. The nodes at the input side / layer represent the receiving nodes for the input parameters as mentioned above, in particular (RF) signal, envelope, signal quality feedback e.g. after filter or power amplifier, time/clock, signal properties, current load, channels, and so on. The nodes at the output side / layer represent the controlling or steering functions of the tunable or adaptable or configurable elements, such as a matching function for one or more switching or tunable element(s) being provided e.g. in adjustable impedance/frequency matching networks, for drain bias modulation or bias switching, for gate bias modulation or bias switching, antenna control, linearization control etc. As described above, the switching/tuning elements may be adapted for frequency and/or impedance matching of one or more of the respective amplifier stages A1 to A3.

One of ordinary skill in the art will readily recognize that the schematic representation of the neural network NN in Fig. 2 is only a simplified example of a neural network suitable e.g. for the intelligent amplification unit A shown in Fig. 1. Other configurations of a neural network suitable for the present invention and having more or less or other input parameters or nodes and more or less or other output nodes as are shown in Fig. 2 are conceivable. In particular, the neural network NN may also comprise a larger number of nodes in the hidden layer, or may comprise more than one hidden layer.

The principle of an intelligent steering, control or tuning is not only suitable for an amplification unit A as it is presented above. The present invention can also be applied to control more parts, e.g. a whole remote antenna head or even a whole RF communication network by one or more neural networks.

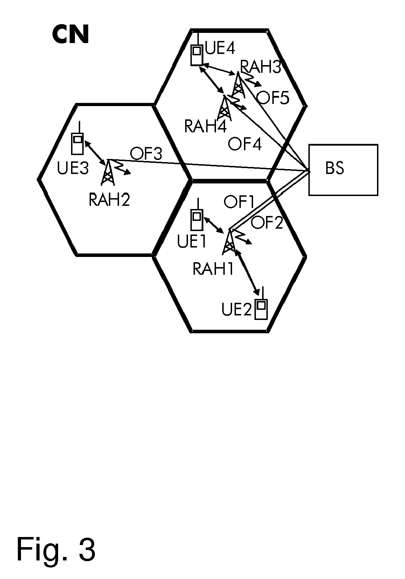

The principle structure of a communication network CN for signal transmission and reception in which the invention can be implemented is shown in **fig. 3**. The communication network CN comprises a base station BS, remote antenna heads RAH1-RAH4 and user terminals UE1-UE4.

Each of said remote antenna heads RAH1-RAH4 is connected to the base station BS by means of at least one optical connection, as e.g. an optical fiber or an optical free-space connection, OF1, OF2, OF3, OF4 and OF5 respectively. Each of said user terminals UE1-UE4 is connected to one or multiple of said remote antenna heads RAH1-RAH4, which is symbolized by double arrows in fig. 3. The base station BS is in turn connected to a core network, which is not shown in fig. 3 for the sake of simplicity.

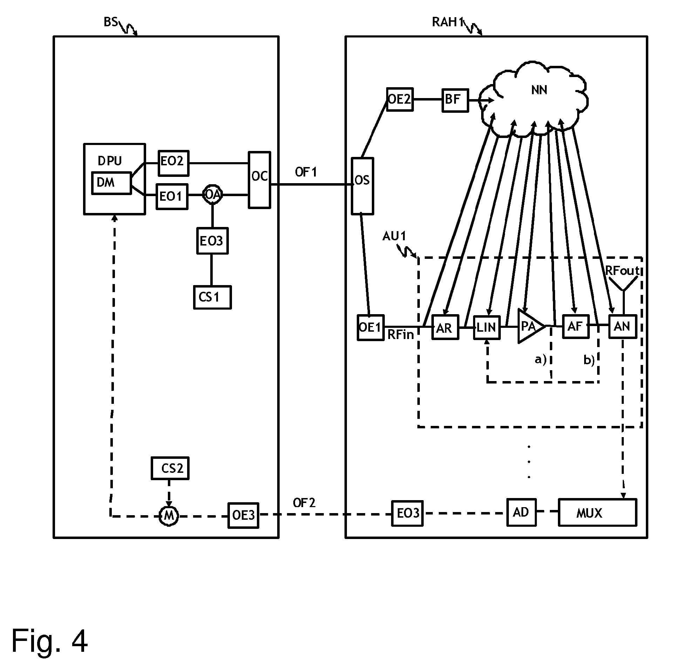

A transmitting device BS, as e.g. a base station, and a receiving device RAH1, as e.g. a remote antenna head, according to an embodiment of the invention are depicted in **fig. 4**.

The transmitting device BS is indicated as a box and comprises a digital signal processing unit DPU with a digital modulator DM, three electro-optical converters EO1, EO2 and EO3, a first carrier synthesizer CS1, an optical adder A, and an optical combiner OC.

The receiving device RAH1 is also indicated as a box and comprises an optical splitter OS, a first and a second opto-electrical converter OE1 and OE2, a baseband filter BF, a neural network NN, and an amplification unit AU1, which is indicated by a dashed box and comprises an analogue reconstruction device AR, a linearization device LIN, a power amplifier PA, an antenna filter AF, and an antenna network AN.

A first output of the digital modulator DM is connected to an input of the first electro-optical converter EO1, and an output of the first electro-optical converter EO1 is connected to a first input of the optical adder OA.

An output of the first carrier synthesizer CS1 is connected to an input of the third electro-optical converter EO3, and an output of the third electro-optical converter EO3 is connected to a second input of the optical adder OA.

An output of the optical adder OA is connected to a first input of the optical combiner OC.

A second output of the digital modulator DM is connected to an input of the second electro-optical converter E02, and an output of the second electro-optical converter E02 is connected to a second input of the optical combiner OC.

An output of the optical combiner OC is connected to an input of the optical splitter OS through an optical connection OF1, as e.g. an optical fiber or an optical free-space connection.

A first output of the optical splitter OS is connected to the input of the first opto-electrical converter OE1, and a second output of the optical splitter OS is connected to the input of the second opto-electrical converter OE2.

An output of the second opto-electrical converter OE2 is connected to an input of the baseband filter BF, and an output of the baseband filter BF is connected to an input of the neural network NN.

The principle functionality and structure of the neural network is as described above under fig. 1 and 2.

The first opto-electrical converter OE1 is connected in series with the analogue reconstruction device AR, the linearization device LIN, the power amplifier PA, the antenna filter AF, and the antenna network AN.

In the digital modulator DM, electrical data signals, as e.g. so-called I and Q data used e.g. in the standard Third Generation Partnership Project Long Term Evolution (3GPP LTE), that the digital modulator DM receives at its input are digitally modulated resulting in electrical digital baseband signals e.g. on a baseband frequency f_{bb} preferably in the frequency range 0-200 MHz.

The digital modulator DM can e.g. be a so-called delta sigma modulator or a pulse-length modulator.

The same electrical digital baseband signals are sent both to the input of the first electro-optical converter EO1, and to the input of the second electro-optical converter E02.

In the first electro-optical converter EO1, the electrical digital baseband signals are converted into optical digital signals using an optical source with f_{optical} being the frequency of the light of the optical source, so that the optical digital signals have a frequency fₒₛ= f_{optical}± f_{bb}.

From the output of the first electro-optical converter EO1, the optical digital signals are sent over an optical connection to the first input of the optical adder OA.

In the carrier synthesizer CS1, electrical radio frequency carrier signals, which can be digital or analogue, on a radio frequency f_{rf} preferably in the frequency range of several hundreds of MHz to several GHz are generated. The electrical radio frequency carrier signals are sent to the third electro-optical converter EO3 for converting the electrical radio frequency carrier signals into optical radio frequency carrier signals using an optical source with f_{optical} being the frequency of the light of the optical source, so that the optical radio frequency carrier signals have a frequency f_{orf}= f_{optical}± f_{rf}.

From the output of the third electro-optical converter EO3, the optical radio frequency carrier signals are sent over an optical connection to the second input of the optical adder OA.

In the optical adder OA, the optical digital signals are added with the optical radio frequency carrier signals, i.e. the optical digital signals with the frequency fₒₛ= f_{optical}± f_{bb} are summed up with the optical radio frequency carrier signals with the frequency f_{orf}= f_{optical}± t_{rf}, and transmitted from the output of the optical adder OA to the first input of the optical combiner OC.

In the second electro-optical converter EO2, the electrical digital baseband signals are converted into optical digital signals using an optical source with the frequency of the light f' _{optical} of the optical source being different from the frequency of the light f_{optical} of the optical source of the first electro-optical converter EO1, so that the optical digital signals have a frequency f' ₒₛ= f'_{optical}± f_{bb}.

From the output of the second electro-optical converter E02, the optical digital signals are sent to the second input of the optical combiner OC.

In the optical combiner OC, the optical digital signals with the frequency fₒₛ= f_{optical}± f_{bb} and the optical radio frequency carrier signals with the frequency f_{orf}= f_{optical}± f_{rf}, which have been summed up in the optical adder OA, are summed up with the optical digital signals with the frequency f'ₒₛ= f'_{optical}± f_{bb}, which results in combined optical signals.

From the output of the optical combiner OC, the combined optical signals are sent over the optical connection OF1, which can be e.g. an optical fiber or an optical free-space connection, to an input of the optical splitter OS located in the receiving device RAH1.

In the optical splitter OS, the optical digital signals with the frequency fₒₛ= f_{optical}± f_{bb} and the optical radio frequency carrier signals with the frequency f_{orf}= f_{optical}± f_{rf} are separated from the optical digital signals with the frequency f'ₒₛ= f'_{optical}± f_{bb} based on the optical carrier wavelength and transmitted to the input of the first opto-electrical converter OE1 and the input of the second opto-electrical converter OE2 respectively.

In the first opto-electrical converter OE1, the principle of optical heterodyning is applied, and the optical digital signals are upconverted into electrical digital radio frequency signals. The intensity of the detected electrical radio frequency signals varies with a frequency f_{des}=f_{rf}±f_{bb}, as all higher frequency components of the intensity in the range of f_{optical} are time averaged in the first opto-electrical converter OE1.

In an embodiment of the invention, the optical digital signals are not upconverted on a radio frequency using optical heterodyning, but by means of electrical upconversion on the radio frequency before the first electro-optical converter EO1. In the first electro-optical converter EO1, the electrical digital signals on radio frequency level are then converted into optical digital signals, and directly transmitted via the optical connection OF1 to the input of the opto-electrical converter OE1.

The digital electrical radio frequency signals RFin are sent from an output of the first opto-electrical converter OE1 to an input of the analogue reconstruction device AR in which analogue radio frequency signals are recovered. Said analogue reconstruction device AR can e.g. be a so-called reconstruction filter in case of delta sigma modulated or pulse width modulated digital electrical radio frequency signals.

The analogue radio frequency signals are sent from the output of the analogue reconstruction device AR via a linearization device LIN to an input of the power amplifier PA for amplification. An amplified copy of the analogue radio frequency signals is sent from the output of power amplifier PA to the input of the antenna filter AF.

The amplified analogue radio frequency signals are filtered in the antenna filter AF, and sent to the antenna network AN for transmission over an air interface. The antenna filter AF blocks the unwanted spectral fractions, i.e. the out-of-band fractions, of the signal and passes the desired spectral fraction, i.e. the in-band fraction, of the signal to the antenna. Said antenna filter can e.g. be a bandpass filter with suitable frequency characteristic and matching performance.

In the second opto-electrical converter OE2, the optical digital signals are back-converted into electrical digital baseband signals, which are transmitted via a baseband filter to the neural network NN as an input parameter for controlling the amplification unit AU1 as described above under fig. 1 and 2.

As further input parameters for controlling the amplification unit AU1, radio frequency signals are tapped after the first electro-optical converter OE1, the analogue reconstruction device AR, the linearization device LIN, the power amplifier PA, and the antenna filter AF, and are transmitted to the neural network NN. This is indicated by arrows pointing from the respective devices to the neural network NN in fig. 4. Alternatively, not the tapped radio frequency signals, but deduced signal qualities or signal properties can be transmitted to the neural network NN. Additionally, also the input parameters as mentioned above under fig. 1 and fig. 2, as current load, channels, time/clock and so on can be used.

The neural network NN controls the analogue reconstruction device AR, the linearization device LIN, the power amplifier PA, the antenna filter AF, and the antenna network AN in dependence of the input parameters as described above under fig. 1 and 2. This is indicated by arrows pointing from the neural network NN to the respective devices in fig. 4.

In the following, an embodiment is described for linearization of the amplification unit AU1, which is also depicted in fig. 4.

In the embodiment of the invention, the transmitting device BS further comprises a mixer M, a second carrier synthesizer CS2, and a third opto-electrical converter OE3, and the receiving device RAH1 further comprises a multiplexer MUX, an analogue-to-digital converter AD, and a third electro-optical converter EO3.

The embodiment for linearization of the amplification unit AU1 is based on a feedback of a sample of the amplified electrical analogue signals. The amplified electrical analogue signals are tapped e.g. at the antenna network AN.

The tapped electrical analogue signals are fed to the multiplexer MUX in which the electrical radio frequency signals of the amplification unit AU1 can be time-multiplexed with electrical analogue signals of further amplification units. The electrical analogue signals are transmitted from the multiplexer MUX to the analogue-to-digital converter AD, in which the electrical analogue signals are converted into electrical digital signals.

Afterwards the electrical digital signals are converted into optical digital signals in the third electro-optical converter EO3, and are transmitted via an optical connection OF2, as e.g. an optical fiber or an optical free-space connection to the third opto-electrical converter OE3 located in the transmitting device BS, in which the optical digital signals are converted back into electrical digital signals.

Then the electrical digital signals are sent via a reconstruction filter, which is not shown in fig. 4, to the mixer M in which they are downconverted to baseband level by means of electrical analogue radio frequency carrier signals generated in the second carrier synthesizer CS2.

Finally, the downconverted electrical analogue signals are fed to the digital signal processing unit DPU for baseband linearization. The digital signal processing unit DPU in this embodiment additionally comprises an anti-aliasing filter and an analogue-to-digital converter, which are not shown in fig. 4, for filtering and conversion into the digital domain of the downconverted electrical analogue signals.

In a variant of the embodiment, not the tapped electrical analogue signals are transmitted back to the digital signal processing unit DPU, but merely a control information for baseband linearization which has been calculated in the receiving device RAH1.

In another embodiment of the invention, tapped amplified electrical analogue signals are fed back to the linearization device LIN.

The embodiment is based on a linearization on a radio frequency level. In a first alternative, which is indicated by a), the electrical analogue signals are tapped directly after the power amplifier PA and fed to the linearization device LIN. Based on the measured deviation of the electrical analogue data signals from the theoretical ideally, i.e. linearly, amplified signal the linearization device LIN derives a compensation signal which is then fed to the input of the power amplifier PA, resulting in linearity-improved overall output signals. Said linearization device LIN can e.g. be a fast differential amplifier with suitable characteristic which is driven by the scaled input and output signal of the power amplifier PA. In a second alternative, which is indicated by b), the electrical analogue signals are tapped after the antenna filter AF and fed to the linearization device LIN. As in the first alternative described above, the electrical analogue signals are conditioned in the linearization device LIN and then fed to the input of the power amplifier PA, resulting in linearity-improved overall output signals.

Preferably, each of said electro-optical converters EO1, E02 and EO3 comprises a laser diode which is either directly modulated or externally modulated e.g. by means of a electroabsorption or lithiumniobate modulator.

Preferably, said opto-electrical converters OE1, OE2 and OE3 comprise a so-called PIN-diode or a so-called avalanche-photodiode.

In the embodiment described above, only one active antenna element, i.e. only one amplification unit AU1, is used for signal transmission. However, the principal idea of the invention can also be applied to systems with more than one active antenna element, i.e. with more than one amplification unit.

## Claims

1. A method for transmission of signals from a transmitting device (BS) to at least one receiving device (RAH1) comprising at least one amplification unit (A, AU1) for signal amplification, wherein said signals are transmitted over at least one optical connection (OF1) from the transmitting device (BS) to the at least one receiving device (RAH1) **characterized in, that**
• electrical baseband signals are converted into optical signals in the transmitting device (BS),
• the optical signals are converted into electrical radio frequency signals in an opto-electrical converter (OE1) located in said at least one receiving device (RAH1),
• and the electrical radio frequency signals are amplified in the at least one amplification unit (A, AU1) with the steps of
- inputting the electrical radio frequency signals (RFin) to be amplified,
- outputting amplified radio frequency output signals (RFout),
- and tuning or configuring at least one tunable amplification parameter (GB, DB) in accordance with at least one input parameter (IP1 to IP5), wherein
- said tuning, or configuring of said at least one tunable amplification parameter (GB, DB) is carried out by steering it by means of at least one neural network (NN) on the basis of said at least one input parameter input to said at least one neural network (NN).

2. A method according to claim 1, **characterized in, that** the electrical baseband signals are transmitted to said at least one neural network (NN) as one of said at least one input parameter (IP1).

3. A method according to any of the preceding claims, **characterized in, that** the optical signals are converted into electrical radio frequency signals applying optical heterodyning in the opto-electrical converter (OE1).

4. A method according to any of the preceding claims, **characterized in, that** said at least one tunable amplification parameter (GB, DB) comprises one or more parameters of a group consisting of: power amplifier's gate biasing modulation, power amplifier's drain biasing modulation, and switchable or tunable radio frequency signal impedance or frequency matching.

5. A method according to any of the preceding claims, **characterized in, that** said at least one input parameter (IP1 to IP5) to said at least one neural network (NN) comprises one or more parameters of the group consisting of: radio frequency input signals, radio frequency output signals, addressed communication standard, communication standard requirements, number of radio frequency carriers, number of signal channels, current load, signal properties, signal envelope, measured output or transmit signals, and time.

6. A method according to any of the preceding claims, **characterized in, that** said at least one neural network (NN) decides based on said at least one input parameter about a required amplification configuration by controlling said at least one tunable or configurable parameter (GB, DB).

7. A method according to any of the preceding claims, **characterized in, that** said at least one neural network (NN) learns about current conditions or scenarios and recognizes conditions or scenarios for the future based on said at least one input parameter (IP1 to IP5).

8. A transmitting device (BS) for transmission of signals to at least one receiving device (RAH1) **characterized in, that** said transmitting device (BS) comprises
• a digital signal processing unit (DPU) for generating electrical digital signals,
• a first electro-optical converter (EO1) for converting said electrical digital signals into first optical digital signals on baseband level,
• a second electro-optical converter (EO2) for converting said electrical digital signals into second optical digital signals on baseband level,
• a third electro-optical converter (EO3) for converting electrical radio frequency carrier signals into optical radio frequency carrier signals,
• an optical adder (OA) for adding the second optical digital signals on baseband level and the optical radio frequency carrier signals,
• and at least one optical output that is adapted to transmit the first optical digital signals on baseband level, the second optical digital signals on baseband level, and the optical radio frequency carrier signals.

9. A transmitting device (BS) according to claim 8, **characterized in, that** said transmitting device (BS) is a base station (BS) for transmission of signals via a remote antenna head (RAH1) to a user terminal (UE1).

10. A receiving device (RAH1) for reception of signals sent from a transmitting device (BS) **characterized in, that** said receiving device (RAH1) comprises
• at least one optical input that is adapted to receive optical signals,
• an opto-electrical converter (OE1) that is adapted to convert optical signals into electrical radio frequency signals,
• and at least one amplification unit (A, AU1) configured for amplifying said electrical radio frequency signals, said amplification unit (A, AU1) comprising
- a radio frequency signal input terminal (IN) for inputting said electrical radio frequency input signal (RFin) to be amplified by said amplification unit (A, AU1),
- a radio frequency signal output terminal (OUT) for outputting radio frequency output signals (RFout) amplified by said amplification unit (A, AU1), and
- at least one tunable or configurable element (GB, DB),
- wherein said amplification unit (A, AU1) further comprises or is coupled with at least one neural network (NN) configured to steer said at least one tunable or configurable element (GB, DB) on the basis of at least one input parameter (IP1 to IP5) input to said at least one neural network (NN).

11. A receiving device (RAH1) according to claim 10, **characterized in, that** the opto-electrical converter (OE1) is adapted to apply optical heterodyning to convert the optical signals into said electrical radio frequency signals.

12. A receiving device (RAH1) according to claim 10 or 11, **characterized in, that** the receiving device (RAH1) comprises a further opto-electrical converter (OE2) that is adapted to convert optical signals on baseband level into electrical signals on baseband level, and that is adapted to transmit the electrical signals on baseband level to said at least one neural network (NN) as one of said at least one input parameter (IP1 to IP5).

13. A receiving device (RAH1) according to any of the claims 10, 11 or 12, **characterized in, that** said at least one neural network (NN) is configured to decide based on said at least one input parameter (IP1 to IP5) about a required amplifier configuration by controlling said at least one tunable or configurable element (GB, DB).

14. A receiving device (RAH1) according to any of the claims 10, 11, 12 or 13, **characterized in, that** said receiving device (RAH1) is a remote antenna head for reception of signals sent from a base station (BS).
